# EUROPEAN PATENT SPECIFICATION

(11) **EP 0 536 667 B1**
(45) Date of publication and mention of the grant of the patent: **08.01.1997**
(21) Application number: 92116959.5
(22) Date of filing: 05.10.1992
(51) Int. Cl.: H03F 3/45, G01D 3/02

(54) **Analogue signal processor**
Verarbeiter für analoge Signale
Dispositif de traitement des signaux analogiques

(30) Priority: 07.10.1991 JP 285454/91; 13.04.1992 JP 118541/92
(43) Date of publication of application: 14.04.1993
(73) Proprietor: MITSUBISHI DENKI KABUSHIKI KAISHA, Tokyo 100 (JP)
(72) Inventor: Egami, Noritaka c/o Mitsubishi Denki, Nagasaki-shi, Nagasaki (JP)
(74) Representative: KUHNEN, WACKER & PARTNER

(56) References cited:
- EP-A- 0 367 927
- US-A- 4 155 263

## Description

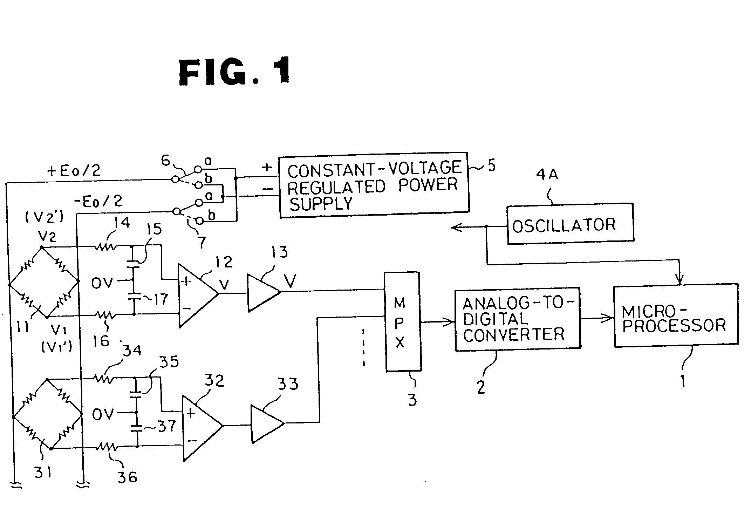

This invention relates to a circuit for converting analog input signals provided by at least one measuring bridge into digital output signals which circuit enables minute analog signals obtained from a strain gage, etc. to be read as digital values. In order to facilitate the understanding of the present invention, a discussion of prior art will follow making reference to Fig. 1 to 3 of the drawings.

Figure 1 is a block diagram showing a conventional analog input apparatus shown in Japanese Utility Model Laid-Open No. Sho 58-59218 as an example, wherein numeral 1 is a microprocessor which contains a memory, etc., and reads digital values of an analog-to-digital converter (described below) for data processing; numeral 2 is an analog-to-digital converter which converts a voltage value selected by means of a multiplexer into digital form; numeral 3 is an analog multiplexer for selecting one out of several analog input points; numeral 4A is an oscillator with a duty ratio of 1:1; numeral 5 is a constant-voltage regulated power supply as a bipolar voltage power supply for generating bipolar voltage; numerals 6 and 7 are switches such as mercury contact relays; numerals 11 and 31 are strain gages as bridge measuring devices for measuring distortion caused by external force; numerals, 12 and 32 are high input impedance differential amplifiers (hereinafter simply referred to as amplifiers); numerals 13 and 33 are forward amplifiers; numerals 14 and 16 and 15 and 17 are resistors and capacitors respectively making up a low-pass filter; and numerals 34 and 36 and 35 and 37 are resistors and capacitors respectively making up a low-pass filter.

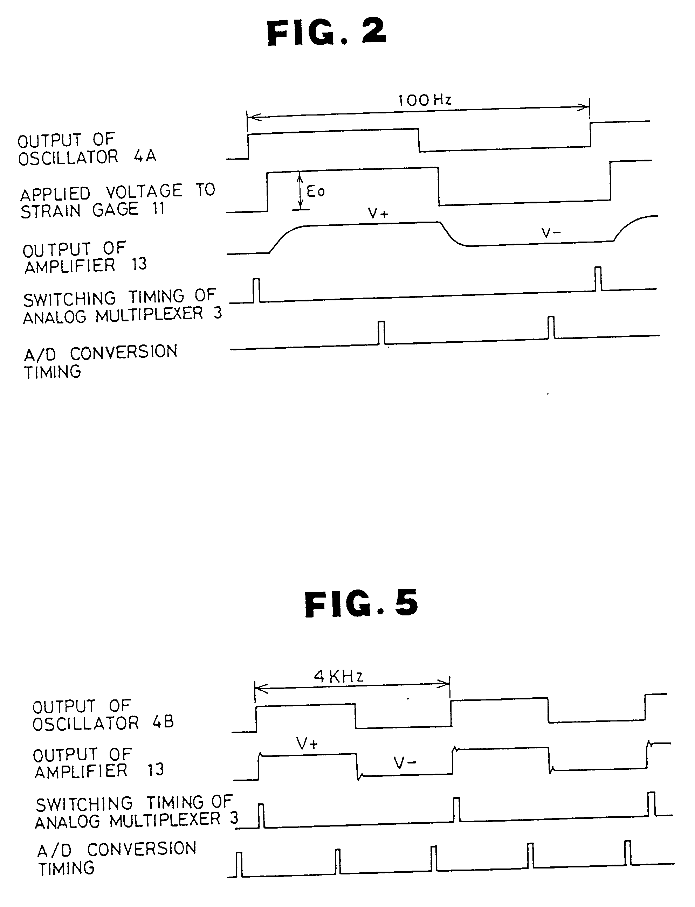

Referring now to the timing chart shown in Figure 2, operation is described. When the low-to-high transition of an output of the oscillator 4A is made, a contacts of the switches 6 and 7 are turned on, applying +E₀ (V) to the strain gage 11. At the time, assuming that voltages which are minute analog values appearing due to strain gage distortion are v₂ and v₁, distortion containing an offset is ε, and output voltages of the amplifier 12 and forward amplifier 13 are v₊ and V₊, the difference between voltages v₂ and v₁ is as follows:${\text{v}}_{\text{2}} {\text{- v}}_{\text{1}} {\text{= E}}_{\text{0}} {\text{· (K}}_{\text{ε}} \text{/4)}$ wherein ε is distortion obtained from the strain gage and K is a constant determined by the strain gage.

Therefore, the output of the amplifier 12 is as follows:${\text{v}}_{\text{+}} {\text{= g}}_{\text{1}} {\text{(v}}_{\text{2}} {\text{- v}}_{\text{1}} {\text{) + α(v}}_{\text{2}} {\text{+ v}}_{\text{1}} {\text{) + β}}_{\text{1}}$ wherein g₁ is the gain of the differential amplifier, in which case the gain is set to about several hundred times higher because the voltages v₁ and v₂ are minute voltages in mV units, α is the amplification factor for common mode potential which is ideally zero, but actually 5 has a slight value, and β₁ is the offset of the differential amplifier.

With the voltage v₊, as input, the following output voltage V₊ is obtained at the forward amplifier 13:${\text{V}}_{\text{+}} {\text{= g}}_{\text{2}} {\text{v}}_{\text{+}} {\text{+ β}}_{\text{2}} {\text{= g}}_{\text{2}} {\text{g}}_{\text{1}} {\text{(v}}_{\text{2}} {\text{- v}}_{\text{1}} {\text{) + g}}_{\text{2}} {\text{α(v}}_{\text{2}} {\text{+ v}}_{\text{1}} \text{)} {\text{+ g}}_{\text{2}} {\text{β}}_{\text{1}} {\text{+ β}}_{\text{2}}$ wherein g₂ and β₂ are the gain and offset of the forward amplifier 13 respectively.

Next, when the high-to-low transition of the output of the oscillator 4A is made, b contacts of the switches 6 and 7 are turned on, applying -E₀ (V) to the strain gage 11. At the time, assuming that voltages appearing due to stain gage distortion are $\overline{\text{v}}$₂ and $\overline{\text{v}}$₁ and output voltage of the forward amplifier 13 is V₋, the difference between voltages $\overline{\text{v}}$₂ and $\overline{\text{v}}$₁ is as follows:${\overline{\text{v}}}_{\text{1}} \text{-} {\overline{\text{v}}}_{\text{2}} {\text{= E}}_{\text{0}} {\text{· (K}}_{\text{ε}} \text{/4)}$

Therefore, the output voltage of the forward amplifier 13 is as follows:${\text{V- = g}}_{\text{2}} {\text{g}}_{\text{1}} \text{(} {\overline{\text{v}}}_{\text{1}} \text{-} {\overline{\text{v}}}_{\text{2}} {\text{) + g}}_{\text{2}} \text{α(} {\overline{\text{v}}}_{\text{2}} \text{+} {\overline{\text{v}}}_{\text{1}} {\text{) + g}}_{\text{2}} {\text{β}}_{\text{1}} {\text{+ β}}_{\text{2}}$

Consequently, from the expressions (1), (4), (3), and (5), the difference between voltages V₊ and V₋ is as follows:${\text{V}}_{\text{+}} {\text{- V}}_{\text{-}} {\text{= 2g}}_{\text{2}} {\text{g}}_{\text{1}} {\text{(v}}_{\text{2}} {\text{- v}}_{\text{1}} {\text{) +g}}_{\text{2}} {\text{α[(v}}_{\text{2}} {\text{+ v}}_{\text{1}} \text{) - (} {\overline{\text{v}}}_{\text{2}} \text{+} {\overline{\text{v}}}_{\text{1}} \text{)]}$

Since the second term of expression (6) is near 0, the following is established:$\left|{\text{g2α[(v}}_{\text{2}} {\text{+v}}_{\text{1}} \text{)-(} {\overline{\text{v}}}_{\text{2}} \text{+} {\overline{\text{v}}}_{\text{1}} \text{)]}\right| {\text{< 2g}}_{\text{2}} {\text{g}}_{\text{1}} {\text{(v}}_{\text{2}} {\text{- v}}_{\text{1}} \text{)}$

Therefore, the offset constituent is removed and distortion ε can be measured from expressions (1) and (6). An error of the strain gage 11 itself is corrected by the microprocessor from measurement data of the gage. The voltage E₀ of the constant-voltage regulated power supply 5 and the gains g₁ and g₂ are hard to change as compared with the offset. The circuit related to the strain gage 11 is described above; the same also applies to the circuit related to the strain gage 31.

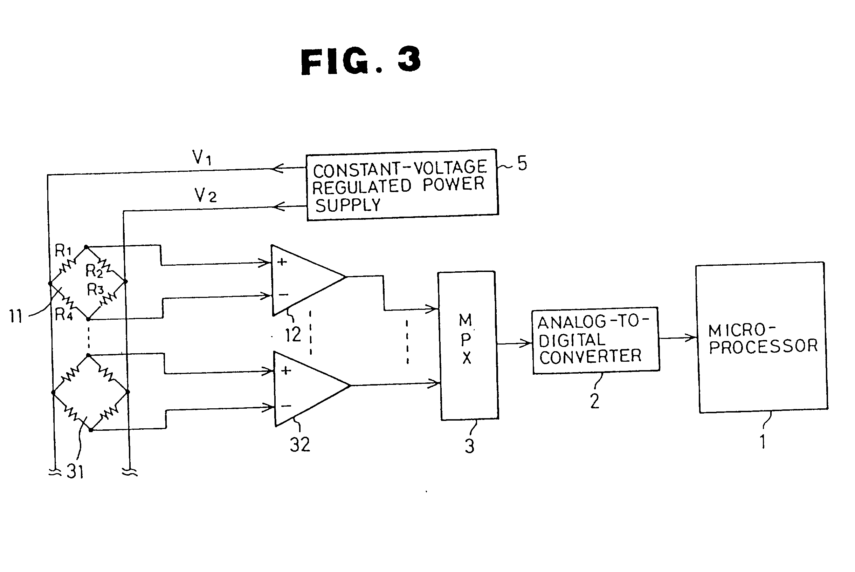

Figure 3 is a block diagram illustrating a former analog input method, wherein numerals 11-31 are strain gages where the resistance value of one of the arms (for example, R₁) changes with the magnitude of distrotion caused by external force, and make up a bridge circuit; numeral 5 is a constant-voltage regulated power supply for applying predetermined supply voltages V₁ and V₂ to the strain gates 11-31; numerals 12-32 are high input impedance differential amplifiers which differentially amplify voltages v₁ and v₂ obtained from two middle points of each of the strain gages 11-31; numeral 3 is a multiplexer for selectively reading one among voltage values v differentially amplified and output by the differential amplifiers 12-32; and numeral 2 is an analog-to-digital converter which converts the analog voltage value v selected at the multiplexer 3 into digital form.

Next, operation is decribed. When predetermined supply voltages V₁ and V₂ are applied to the strain gages 11-31 from the constant-voltage regulated power supply, the voltages v₁ and v₂ corresponding to the ratio of resistance values of arms R₁-R₄ are obtained from the two middle points of each of the strain gages 11-31. The relationship between the middle-point voltages v₁ and v₂ and the supply voltages V₁ and V₂ is given from the above-mentioned expression (1) by replacing E₀ of the expression with (V₂-V₁).

The output voltage values v of the differential amplifiers 12-32, thus amplified, are fed into the multiplexer 3 which then selects one among the voltage values and sends it to the analog-to-digital converter. The selected analog voltage value v is converted into digital form by the analog-to digital converter 2.

Former analog input apparatus are configured as described above. Thus, when the operating temperature range exceeds 100°C like 0-125°, when the offset of the amplifier 12 at the first stage changes 1 millivolt or more in terms of gain 1, distortion is small, and it is necessary to raise the gain 1000 times higher, if, for example, the voltage generated due to distortion is made a maximum of 1 millivolt, the gain of the amplifier 12 at the first stage is multiplied by 70, and the gain of the forward amplifier 13 at the second stage is multiplied by 70, the value of g₂ β₁ in expression (3) becomes no less than "1 millivolt of offset voltage in terms of gain 1 x 70 x 70 = 4.9 volts."

Thus, normally the signal also becomes 1 millivolt x 70 x 70 and reaches no less than 9.8 volts in total. If the input range of the analog-to-digital converter 2 is ±5 volts, that value exceeds this input range. This means that the offset is too large and the gains of the amplifier 12 and forward amplifier 13 cannot be raised. That is, in this case, problems arise such that the gains must be halved, affecting the measurement precision.

When the switches 6 and 7 switch, because of affection of the above-mentioned low-pass filter, rise and fall of output of the forward amplifier 13 become slow and the on/off time of the switches 6 and 7 is slow, thus the read time of analog input becomes slow and the strain gage state also changes, thus problems arise such that when a large number of analog inputs are attempted to be read, it is inevitable to prolong the time because of time constant limits although it should be shorter.

Furthermore, if voltage supplied to the constant-voltage regulated power supply 5 is switching power supplies, output of the power supply 5 also carries spike noise and the above-mentioned resistors 14 and 16 and capacitors 15 and 17 making up the low-pass filter become necessary to remove the spike noise. If the low-pass filter is taken out, precision is adversely affected.

As is obvious from expression (6), it becomes difficult to remove the common mode constituent, and if the common mode gain of the amplifier 12 cannot be made small, precision is adversely affected.

Furthermore, even if the amplifier is adjusted, at room temperature, to set offset β to substantially "0", the amplifier gain g is large, thus even a slight change in the offset voltage causes large affection to occur. Particularly, if the operating temperature range is wide, the fluctuation value with the temperature change is difficult to estimate and measurement precision is adversely affected. If temperatures affect the supply voltages V₁ and V₂ output from the constant-voltage regulated power supply 5, as is obvious from expression (1), it is inevitable to affect measurement precision. The supply voltages applied to the strain gages, V₁ and V₂, are made the same positive and negative voltages and the resistance values are set to substantially the same to make the common mode voltage (v₂ +v₁) substantially "0", thereby ignoring the term α(v₂ + v₁) of expression (2). However, this measure requires that such setting must be made that the common mode voltage (v₂ +v₁) becomes "0".

It is furthermore known from US-Patent 4 155 263 to connect a plurality of strain gages in a measuring bridge circuit a pair of input terminals of which being fed by a DC voltage source whereas the pair of output terminals of the measuring bridge circuit is connected to a multiplexer arrangement having the shape of two changeover switches. The output of the multiplexer arrangement is connected to differential amplifier means comprising two amplifiers and having its output connected to a demultiplexer. The multiplexer and the demultiplexer, in this known circuit, are synchronously operated by a control signal generating oscillator.

Thus, the ciruit in accordance with U.S.-patent 4,155,263 comprises a multiplexer arrangement connected to a measuring bridge which multiplexer arrangement, however, does not switch the diagonal bridge output voltage and its inversion, respectively, to the amplifier means mentioned before. Such amplifier means, in the known circuit, consist of first and second amplifier means with an RC-network connected in between. This network does not serve for differentiation of the output of the first amplifier. The output of the second amplifier, in the known circuit, is further processed without being converted into digital form and without digital data processing.

European patent application 89 11 58 25.5 (publication number 0 367 927) discloses a sensor arrangement, particularly for pressure sensors, providing differential output signals of the sensor being switched between two amplifiers and thereafter converted in digital form by a microcomputer so that, in storage means of the microcomputer, a respective pair of digital signals corresponds to a predetermined measuring output signal from the sensor in order to cancel an amplifier offset of the two amplifiers in further processing.

The publication just mentioned, therefore, discloses a measuring sensor arrangement fed by a bipolar DC voltage power supply and having its output terminals connected to two analog multiplexers which, in turn, are coupled to an amplifier each. An analog-/digital-conversation and further data processing take place in the microcomputer of the known circuit. The two amplifiers of this circuit are not series connected or cascaded and are not provided with differentiation means in between.

In order to solve the problems mentioned above in connection with the description of prior art as shown in Figs 1 to 3, it is an object of the invention to provide a circuit for converting analog input signals from at least one measuring bridge into digital output signals, which circuit can sufficiently raise gains over a wide range of operating temperatures, enables high measurement of distortion, etc., which is made hard to be affected by a temperature change, and enables high speed sampling without causing switching delay.

It is also an object of the invention to provide a circuit of the kind referred to before which can effectively remove offsets of differential amplifiers, which sufficiently quicken the switching time of analog multiplexers and can suppress fluctuations of supply voltages and gains, caused by temperatures.

It is a still further object of the invention to provide a circuit of the present kind which can suppress fluctuations of supply voltages, gains, etc., caused by temperatures and can be intended for improvement of measurement precision by correction phase execution and for collecting temperature data at high speed.

Also, it is another object of the invention to provide a circuit of the kind described above which is hard to be affected, by temperature changes.

The above objects mentioned in the first place and the further objects are achieved according to the present invention, by the features of claim 1. Preferred embodiments are subject matter of the claims 2 to 4.

The two analog multiplexers used in a circuit of this invention are responsive to the high or low level of oscillator output for the polarity of amplifier input, thereby suppressing former differential amplifier offset, improving the measurement precision of distortion because of a gain rise, and reading (sampling) analog input at high speed.

According to the main aspect of the invention, there is provided circuit which comprises a bridge measuring device connected to a bipolar DC voltage power supply, two analog multiplexers responsive to an output level of an oscillator for switching a polarity and outputting two outputs of the bridge measuring device, a first amplifier for amplifying bipolar output provided through the analog multiplexers, a differentiation for differentiating output of the first amplifier, a second amplifier and an analog-to digital converter for converting output of the differentiation circuit as amplifier by said second amplifier into digital form and outputting the resultant digital value, thus providing the capabilities of effectively removing offsets in differential amplifiers, etc., and quickening the switching time of the analog multiplexer.

According to another aspect of the invention, there is provided a circuit as defined just before, which comprises calibration resistors connected between the bipolar DC voltage power supply and the analog multiplexers, thus providing the capabilities of effectively removing offsets in differential amplifiers, etc., quickening the switching time of the analog multiplexer, and suppressing fluctuations of supply voltage, gains, etc., caused by temperatures changes.

According to yet another aspect of the invention, there is provided a circuit of the kind as defined above, which comprises a temperature sensor for detecting a temperature and enabling a correction phase to be executed by means of the calibration resistors when a setup temperature changes, thus providing the capabilities of suppressing fluctuations of supply voltage, gains, etc., caused by temperatures changes, improving the measurement precision by correction phase execution, and collecting temperature data at high speed.

### BRIEF DESCRIPTION OF THE DRAWINGS

The above and other objects and novel features of the invention will become more fully apparent upon a reading of the following detailed description taken in conjunction with the accompanying drawings; however, the drawings are given for description and do not limit the scope of the invention; in which:
Figure 1 is a block diagram showing a circuit of the kind under discussion in accordance with prior art;
Figure 2 is a timing chart showing signals at blocks of the circuit shown in figure 1;
Figure 3 is a block diagram illustrating a former circuit of the kind of interest here;
Figure 4 is a block diagram showing a preferred embodiment of a circuit according to the invention;
Figure 5 is a timing chart showing signals at blocks of the circuit shown in Figure 4; and
Figure 6 is a block diagram showing another preferred embodiment of a circuit according to the invention;

### DETAILED DESCRIPTION OF THE PREFERRED EMBODIMENTS

Referring now to the accompanying drawings, there are shown preferred embodiments of the invention.

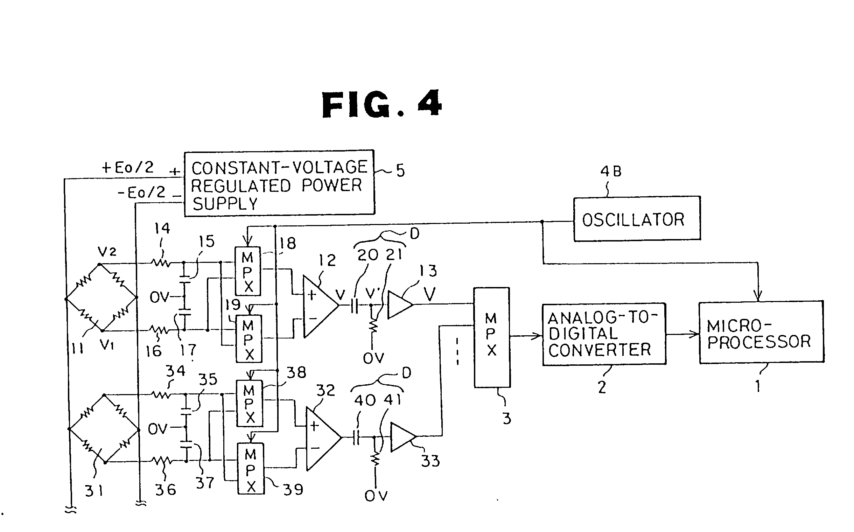

In figure 4, numeral 1 is a microprocessor which contains a memory, etc.; numeral 2 is an analog-to-digital converter; numeral 3 is an analog multiplexer for selecting one out of several analog input points; numeral 4B is an oscillator with a duty ratio of 1:1; and numeral 5 is a constant-voltage regulated power supply as a bipolar voltage power supply for generating bipolar voltage.

Numerals 11 and 31 are strain gages as bridge measuring devices for distortion; numerals 12 and 32 are high input impedance differential amplifiers (hereinafter simply referred to as amplifiers); numerals 13 and 33 are forward amplifiers; numerals 14 and 16 and 15 and 17 are resistors and capacitors respectively making up a low-pass filter; and numerals 34 and 36 and 35 and 37 are resistors and capacitors respectively making up a low-pass filter.

Numerals 18, 19 and 38, 39 are analog multiplexers of 2-input type; numerals 20 and 21 are a capacitor and resistor making up a differentiation circuit D connected between an amplifier 12 and a forward amplifier 13; and numerals 40 and 41 are a capacitor and resistor making up a differentiation circuit D connected between an amplifier 32 and a forward amplifier 33.

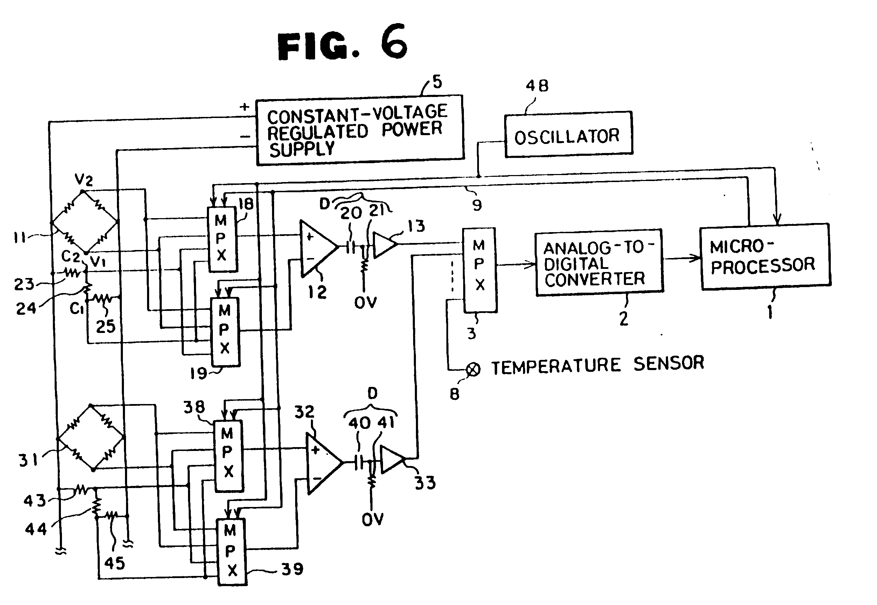

Referring now to the timing chart shown in figure 5, operation is described. When the low-to-high transition of an output of the oscillator 4B is made, the multiplexers 18 and 19 connect the signal from the strain gage 11 to the inputs of the amplifier 12.

At the time, assuming that the minute voltages output by the strain gage 11 are v₂ and v₁, distortion is ε, the output voltage of the amplifier 12 is v₊, and the input and output of the forward amplifier 13 are $\overline{\text{v}}$₊ and V₊, the difference between the output voltages v₂ and v₁, v₂-v₁, becomes as in expression (1) mentioned above and the output of the amplifier 12 becomes as in expression (2) mentioned above.

The input $\overline{\text{v}}$₊ and output V₊ of the forward amplifier 13 become as in the following expressions (8) and (9):${\overline{\text{v}}}_{\text{+}} {\text{= g}}_{\text{1}} {\text{(v}}_{\text{2}} {\text{- v}}_{\text{1}} \text{)}$${\text{V}}_{\text{+}} {\text{= g}}_{\text{2}} {\text{g}}_{\text{1}} {\text{(v}}_{\text{2}} {\text{- v}}_{\text{1}} {\text{) + β}}_{\text{2}}$

Next, when the high-to-low transition of the output of the oscillator 4B is made, the input to the amplifier 12 is inverted and the output voltage v₋ of the amplifier 12 and the input v₋ and output V₋ of the forward amplifier 13 become as follows:${\text{v}}_{\text{-}} {\text{= g}}_{\text{1}} {\text{(v}}_{\text{1}} {\text{- v}}_{\text{2}} {\text{) + α(v}}_{\text{1}} {\text{+ v}}_{\text{2}} {\text{) + β}}_{\text{1}}$${\overline{\text{v}}}_{\text{-}} {\text{= g}}_{\text{1}} {\text{(v}}_{\text{1}} {\text{- v}}_{\text{2}} \text{)}$${\text{V- = g2 g1 (v1 - v2) + β}}_{\text{2}}$

Expressions (8) and (11) do not contain α(v₁ + v₂) as in expression (2) or (10) because differentiation is made. If the switching time of the analog multiplexer is made sufficiently shorter than the time constant of the differentiation circuit D, voltage decrease at the differentiation circuit D can be ignored on precision. Thus, from expressions (9) and (12), the output difference becomes as shown below and from the expression (13) and expression (1), distortion can be found:${\text{V}}_{\text{+}} {\text{- V}}_{\text{-}} {\text{= 2g}}_{\text{1}} {\text{g}}_{\text{2}} {\text{(v}}_{\text{2}} {\text{- v}}_{\text{1}} \text{)}$

Consequently, as obvious from expression (9), only the offset of the forward amplifier 13 at the second stage causes a problem, but is sufficiently small as compared with that of the amplifier 12 at the first stage. That is, even if the operating temperature range is wide, the gains can be raised and the voltage applied to the amplifier 12 depends on the switching speed of the analog multiplexers 18 and 19 and the scan speed can be made high drastically.

As obvious from expression (13), the common mode constituent is removed and precision can be improved. The differentiation circuit D contributes effectively to a raise in the gains in the operating temperature range mentioned above.

Figure 6 shows a further embodiment of the invention wherein numerals 23, 24, and 25, and 43, 44, and 45 are calibration resistors connected between the constant-voltage regulated power supply 5 and the analog multiplexers 18 and 19 and between the power supply 5 and the analog multiplexers 38 and 39. The resistors function so as to cancel affection caused by fluctuations of supply voltages, gains, etc., caused by temperatures. Numeral 8 is a temperature sensor where a low-pass filter is omitted for simplification of the configuration. Next, operation is explained. When a signal 9 output by a microprocessor 1 is low, a minute signal of a strain gage 11 is input (called a measurement phase). When the signal is high, a calibration voltage by means of the calibration resistors 23-25 is input (called a correction phase).

First, the operation in the measurement phase is the same as that in the above-mentioned embodiment and the output voltage difference is as follows from expressions (1) and (13):${\text{V}}_{\text{+}} {\text{- V}}_{\text{-}} {\text{= 2g}}_{\text{1}} {\text{g}}_{\text{2}} {\text{· E}}_{\text{0}} \text{· (Kε/4)}$

Next, when temperature changes greatly, E₀ and g₁ g₂ also change although not so much as the offset of the forward amplifier 13 changes.

Then, a correction phase appears. The operation in the correction phase is similar to that in the measurement phase. Assuming that the voltages at both ends of the calibration resistor 24 are C₂ and C₁ and the output voltages of the forward amplifier 13 are Vt₊ and Vt₋, the potential difference across the calibration resistor 24 is as follows:${\text{C}}_{\text{2}} {\text{- C}}_{\text{1}} {\text{= E}}_{\text{0}} \text{·} {\overline{\text{ε}}}_{\text{o}}$

The difference between the output voltages of the forward amplifier 13 is as follows:${\text{Vt}}_{\text{+}} {\text{- Vt}}_{\text{-}} {\text{= 2g}}_{\text{1}} {\text{g}}_{\text{2}} {\text{(C}}_{\text{2}} {\text{- C}}_{\text{1}} {\text{) = 2g}}_{\text{1}} {\text{g}}_{\text{2}} {\text{· E}}_{\text{0}} \text{·} {\overline{\text{ε}}}_{\text{o}}$

Therefore, the following expressions is obtained from (14) and (16):${\text{(V}}_{\text{+}} {\text{- V}}_{\text{-}} {\text{)/(Vt}}_{\text{+}} {\text{- Vt}}_{\text{-}} \text{) = (Kε/4} {\overline{\text{ε}}}_{\text{o}} \text{)}$ wherein $\overline{\text{ε}}$ₒ can be obtained as a known value from the calibration resistors 23-25 which are very highly precise over a wide range, and as understood from expression (17), the above-mentioned E₀ and g₁ g₂ changes can also be corrected. This enables measurement of very high precision.

Another embodiment uses a temperature sensor for highspeed operation because if measurement and correction phases are repeated alternately to some degree as in the embodiment described before, the sampling period in the measurement phase becomes slow.

Since changes in electric circuit parameters such as E₀ and g₁ g₂ mentioned above are caused by temperature changes, temperature is measured every low period such as once per second, and for example, if a 10° temperature change occurs, a correction phase is executed only at the time, and the measured value is stored.

When a correction phase was executed previously, if the values before execution of the correction phase are also stored, correction phase execution is not required if the temperature rises and falls repeatedly. If there are a large number of measurement points, the correction phase execution time is prolonged and measurement data during the time are missing, thus eliminating the need for executing correction phases has a great effect on the efficiency.

## Claims

1. Circuit for converting analog input signals provided by at least one measuring bridge (11, 31) into digital output signals, comprising:
a bipolar DC voltage power supply (5) connected to the DC input terminals of each measuring bridge (11, 31);
at least one set of two analog multiplexers (18, 19, 38, 39), each measuring bridge being coupled to said two analog multiplexers of the respective set of multiplexers which are controlled by the output signal of an oscillator (4B), the input terminals of each set of multiplexers being connected to the output terminals of the corresponding measuring bridge;
first amplifier means (12, 32) for amplifying the output signals from said analog multiplexers (18, 19, 38, 39);
differentiation means (20, 21; 40, 41) connected to the output of the first amplifier means, said differentiation means having a time constant longer than the switching time of said two analog multiplexers of said at least one set of multiplexers;
second amplifier means (13, 33) connected to the output of said differentiation means; and
an analog-/digital-converter (2) coupled to the output of said second amplifier means and providing, at its output, said digital output signals, said output of said analog-/digital-converter being connected to digital data processing means (1).

2. Circuit in accordance with claim 1, characterized in that calibration resistors (23, 24, 25, 43, 44, 45) are connected between said bipolar DC voltage power supply (5) and said analog multiplexers (18, 19, 38, 39).

3. Circuit in accordance with claim 2, characterized by a temperature sensor (8) for detecting a temperature and enabling a correction phase to be executed by means of said calibration resistors (23, 24, 25, 43, 44, 45) when a set-up temperature changes.

4. Circuit in accordance with claim 1, characterized by a further multiplexer (3) coupled between the output of said second amplifier means (13, 33) and said analog-/digital-converter (2).

## Patentansprüche

1. Schaltung zur Umwandlung von durch mindestens eine Meßbrücke (11, 31) gelieferten analogen Eingangssignalen in digitale Ausgangssignale, enthaltend:
eine bipolare Gleichspannungs-Leistungsquelle (5), die mit den Gleichstrom-Eingangsanschlüssen jeder Meßbrücke (11, 31) verbunden ist;
mindestens ein Satz von zwei analogen Multiplexern (18, 19, 38, 39), wobei jede Meßbrücke mit den genannten beiden analogen Multiplexern des jeweiligen Satzes von Multiplexern gekoppelt ist, welche durch das Ausgangssignal eines Oszillators (4B) gesteuert werden, und wobei die Eingangsanschlüsse jedes Satzes von Multiplexern mit den Ausgangsanschlüssen der entsprechenden Meßbrücke verbunden sind;
erste Verstärkermittel (12, 32) zur Verstärkung der Ausgangssignale von den genannten analogen Multiplexern (18, 19, 38, 39);
Differenziermittel (20, 21; 40, 41), die mit dem Ausgang der ersten Verstärkermittel verbunden sind und eine Zeitkonstante haben, die länger als die Schaltzeit der genannten zwei analogen Multiplexer des mindestens einen Satzes von Multiplexern ist;
zweite Verstärkermittel (13, 33), die mit dem Ausgang der Differenziermittel verbunden sind; und
einen Analog-/Digital-Umsetzer (2), der mit dem Ausgang der genannten zweiten Verstärkermittel gekoppelt ist und an seinem Ausgang die genannten digitalen Ausgangssignale liefert, wobei der Ausgang des genannten Analog/Digital-Umsetzers mit digitalen Datenverarbeitungsmitteln (1) verbunden ist.

2. Schaltung nach Anspruch 1, dadurch gekennzeichnet, daß Eichwiderstände (23, 24, 25, 43, 44, 45) zwischen die genannte bipolare Gleichspannungs-Leistungsquelle (5) und die analogen Multiplexer (18, 19, 38, 39) geschaltet sind.

3. Schaltung nach Anspruch 2, gekennzeichnet durch einen Temperaturfühler (8) zum Detektieren einer Temperatur und zum Ermöglichen einer Korrekturphase, die mittels der genannten Eichwiderstände (23, 24, 25, 43, 44, 45) durchzuführen ist, wenn sich eine Ausgangstemperatur ändert.

4. Schaltung nach Anspruch 1, gekennzeichnet durch einen weiteren Multiplexer (3), der zwischen den Ausgang der zweiten Verstärkermittel (13, 33) und den Analog/Digital-Umsetzer (2) geschaltet ist.

## Revendications

1. Circuit pour convertir des signaux d'entrée analogiques fournis par au moins un pont de mesure (11, 31) en signaux de sortie numériques, comprenant :
une alimentation en tension continue bipolaire (5) reliée aux bornes d'entrée continue de chaque pont de mesure (11, 31) ;
au moins un jeu de deux multiplexeurs analogiques (18, 19, 38, 39), chaque pont de mesure étant couplé auxdits deux multiplexeurs analogiques du jeu respectif de multiplexeurs qui sont contrôlés par le signal de sortie d'un oscillateur (4B), les bornes d'entrée de chaque jeu de multiplexeurs étant reliées aux bornes de sortie du pont de mesure correspondant ;
un premier moyen amplificateur (12, 32) pour amplifier les signaux de sortie desdits multiplexeurs analogiques (18, 19, 38, 39) ;
un moyen de différenciation (20, 21 ; 40, 41) relié à la sortie dudit premier moyen amplificateur, ledit moyen de différenciation ayant une constante de temps plus longue que le temps de commutation des deux multiplexeurs analogiques dudit au moins un jeu du multiplexeurs ;
un second moyen amplificateur (13, 33) relié à la sortie dudit moyen de différenciation ; et
un convertisseur analogique-numérique (2) couplé à la sortie dudit moyen amplificateur et produisant, à sa sortie, lesdits signaux de sortie numériques, lesdites sorties du convertisseur analogique-numérique étant reliées au moyen de traitement de données numériques (1).

2. Circuit selon la revendication 1, caractérisé en ce que des résistances de calibrage (23, 24, 25, 43, 44, 45) sont reliés entre l'alimentation précitée en tension continue bipolaire (5) et les multiplexeurs analogiques précités (18, 19, 38, 39).

3. Circuit selon la revendication 2, caractérisé par un détecteur de température (8) pour détecter une température et permettant à une phase de correction d'être exécutée au moyen des résistances de calibrage précitées (23, 24, 25, 43, 44, 45) lorsqu'une température étalie change.

4. Circuit selon la revendication 1, caractérisé par un autre multiplexeur (3) couplé entre la sortie du second moyen amplificateur précité (13, 33) et le convertisseur analogique-numérique précité (2).
